# EUROPEAN PATENT APPLICATION

(11) **EP 4 742 280 A1**
(43) Date of publication of application: **13.05.2026**
(21) Application number: 24212332.1
(22) Date of filing: 12.11.2024
(51) Int. Cl.: H01F 6/00

(54) **MAGNET APPARATUS WITH COMMUNICATION LINK TO POWER SUPPLY AND ASSOCIATED METHOD**

(71) Applicant: Koninklijke Philips N.V., 5656 AG Eindhoven (NL)
(72) Inventor: LIPS, Oliver, Eindhoven (NL); FORTHMANN, Peter, Eindhoven (NL); VERNICKEL, Peter, 5656AG Eindhoven (NL)
(74) Representative: Philips Intellectual Property & Standards

(57) **Abstract**

An apparatus includes a magnet comprising an electrically superconductive coil adapted to function in a driven mode. A magnet controller (210) is connected to the magnet. A power supply (122) adapted to provide direct current (DC) power to the magnet. An electrical connection is provided between the magnet to provide the DC power to the magnet. A communication interface (206) adapted to communicate signals across the cable between the power supply (122) and the magnet controller (210). The signals between the communication interface (206) and the magnet controller (210) are high-frequency (HF) signals that do not substantially interfere with the DC power transmitted across the cable.

## Description

### BACKGROUND

Magnetic Resonance Imaging (MRI) devices comprise superconducting magnets used to generate the DC magnetic fields needed for MR imaging. Typical MR magnets comprise main coils and shield coils, with the main coils adapted to generate the main magnetic field and the shield coils adapted to shield the MRI device from stray fields often generated by gradient coils of the MRI device.

A large static magnetic field (B₀ field or main magnetic field) is used by Magnetic Resonance Imaging (MRI) scanners to align the nuclear spins of atoms as part of the procedure for producing images within the body of a patient. Traditionally MRI scanners have used superconducting coils that have their current ramped up with a power supply and then the power supply is removed. These magnets are operated in the so-called persistent mode. Although additional electrical current is not needed, such magnetic resonance imaging magnets use a cryostat to keep the superconducting windings, and this may be costly.

Some newer magnetic resonance imaging magnets use superconducting coils from high temperature superconductors or other materials such as MgB₂ which have less stringent cooling requirements. Such magnets may be operated in a so-called driven mode, where amounts of current are continuously supplied to the superconducting coils to maintain the main magnetic field. Overall, these newer magnetic designs have shown to have the potential to reduce the overall operating cost for a magnetic resonance imaging system.

In driven mode operation, a power supply remains connected to the superconducting magnet and provides current to the superconducting magnet during operation. As such, the power supply is an essential element of the MR system. Notably, if the function of the power supply is compromised, severely deleterious result can occur. For example, if the power supply fails while the magnet is energized, an undesirable quench of the superconducting magnet can occur. Moreover, a disconnection of the power supply during operation is not desirable and should be avoided.

Accordingly, while superconducting magnets configured to function in driven mode show promise for future applications, including applications in the medical field, known systems are deficient in proper safeguards to prevent unintended interruption of power to the superconducting magnet during driven mode operation. What is needed, therefore, is an apparatus that overcomes at least the noted drawbacks of known superconducting magnets adapted to operate in driven mode.

### SUMMARY

In accordance with a representative embodiment, an apparatus, comprises: a magnet comprising an electrically superconductive coil adapted to function in a driven mode; a magnet controller connected to the magnet; a power supply adapted to provide direct current (DC) power to the magnet; an electrical connection disposed between the magnet to provide the DC power to the magnet; and a communication interface adapted to communicate signals across the cable between the power supply and the magnet controller. The signals between the communication interface and the magnet controller are high-frequency (HF) signals that do not substantially interfere with the DC power transmitted across the cable.

In accordance with another representative embodiment, a magnetic resonance imaging (MRI) device, comprises: a magnet comprising an electrically superconductive coil adapted to function in a driven mode; a magnet controller connected to the magnet; a power supply adapted to provide direct current (DC) power to the magnet; an electrical connection disposed between the magnet to provide the DC power to the magnet; and a communication interface adapted to communicate signals across the cable between the power supply and the magnet controller. The signals between the communication interface and the magnet controller are high-frequency (HF) signals that do not substantially interfere with the DC power transmitted across the cable.

### BRIEF DESCRIPTION OF THE DRAWINGS

The example embodiments are best understood from the following detailed description when read with the accompanying drawing figures. It is emphasized that the various features are not necessarily drawn to scale. In fact, the dimensions may be arbitrarily increased or decreased for clarity of discussion. Wherever applicable and practical, like reference numerals refer to like elements.
Fig. 1 is a simplified schematic diagram of a medical system according to a representative embodiment.
Fig. 2 is a simplified schematic diagram of a power supply connected to a magnet controller of a magnet according to a representative embodiment.
Fig. 3 is a flow-chart of a method of initiating ramp-up of a magnet in driven mode according to a representative embodiment.
Fig. 4 is a flow-chart of a method of checking on a status of a power supply and actions taken by a magnet controller based on the status of the power supply according to a representative embodiment.
Fig. 5 is a flow-chart of a method of performing a rapid ramp down of a driven magnet according to a representative embodiment.

### DETAILED DESCRIPTION

In the following detailed description, for the purposes of explanation and not limitation, representative embodiments disclosing specific details are set forth in order to provide a thorough understanding of embodiments according to the present teachings. However, other embodiments consistent with the present disclosure that depart from specific details disclosed herein remain within the scope of the appended claims. Descriptions of known systems, devices, materials, methods of operation and methods of manufacture may be omitted so as to avoid obscuring the description of the representative embodiments. Nonetheless, systems, devices, materials and methods that are within the purview of one of ordinary skill in the art are within the scope of the present teachings and may be used in accordance with the representative embodiments. It is to be understood that the terminology used herein is for purposes of describing particular embodiments only and is not intended to be limiting. Definitions and explanations for terms herein are in addition to the technical and scientific meanings of the terms as commonly understood and accepted in the technical field of the present teachings.

It will be understood that, although the terms first, second, third etc. may be used herein to describe various elements or components, these elements or components should not be limited by these terms. These terms are only used to distinguish one element or component from another element or component. Thus, a first element or component discussed below could be termed a second element or component without departing from the teachings of the inventive concept.

As used in the specification and appended claims, the singular forms of terms 'a', 'an' and 'the' are intended to include both singular and plural forms, unless the context clearly dictates otherwise. Additionally, the terms "comprises," and/or "comprising," and/or similar terms when used in this specification, specify the presence of stated features, elements, and/or components, but do not preclude the presence or addition of one or more other features, elements, components, and/or groups thereof. As used herein, the term "and/or" includes any and all combinations of one or more of the associated listed items.

Unless otherwise noted, when an element or component is said to be "connected to" or "coupled to", another element or component, it will be understood that the element or component can be directly connected or coupled to the other element or component, or intervening elements or components may be present. That is, these and similar terms encompass cases where one or more intermediate elements or components may be employed to connect two elements or components. However, when an element or component is said to be "directly connected" or "immediately adjacent" to another element or component, this encompasses only cases where the two elements or components are connected or disposed immediately adjacent to each other without any intermediate or intervening elements or components.

As described herein in connection with various representative embodiments, the present teachings relate to a magnet apparatus comprising superconducting coils that operate in a driven state. A power supply is in constant contact with the magnet apparatus, and provides DC current over an electrical connection. As will be appreciated by one of ordinary skill in the art, the electrical connection may comprise a cable or busbar having capacity to handle transmission of currents necessary to energize a superconducting coil. Over the same electrical connection, a communications link is established and enables communication between a magnet controller and the power supply enabling action to be taken by the magnet controller in a variety of scenarios. Notably, the communications link operates at a comparatively high frequency (HF) over the same connection, and thereby does not add to the complexity of the magnet apparatus, while providing a reliable link for the communication between the magnet apparatus and the power supply during operation of the magnet apparatus. As described more fully below, the communication link providing in accordance with various representative embodiments enables the initial connection of the power supply to the superconducting coils to be safely established. In operation, and as described more fully below, via the communications link, the magnet controller is adapted to detect certain issues in the power supply or the connection, or both, the superconducting coils of the magnet apparatus can ramp down and avoid a quenching event or damage to the magnet apparatus. Moreover, as described herein, ramping down of the superconducting coils of the magnet apparatus can be done by the power supply in a comparatively slow manner; and a comparatively fast ramp down with power discharge over an electrical circuit (e.g., a known diode power discharge circuit). Beneficially, ramp down of the superconducting coils of the magnet apparatus substantially avoids undesired quenching of the superconducting coils.

As described more fully below, the HF signals of the communications link are far removed in frequency and amplitude from the DC current providing the power to the magnet apparatus so substantially no electrical interference occurs during operation of the magnet apparatus including the communications link between the magnet controller and the power supply. As such, given the size of the superconducting coils of the magnet apparatus and the commensurate inductance the superconducting coils creates, the comparatively low power (e.g., of at most a few hundred mW) does not interfere with the function of the superconducting coil, nor does the DC current traversing connection between the power supply and the magnet apparatus interfere with the HF signals being transmitted over the same connection, again because of the disparity between the operating frequencies of the DC current signals and the HF signals.

In various representative embodiments, the HF signals used to provide the communications between the magnet apparatus and the power supply are in the range of approximately 10 kHz to approximately 100 MHz. Notably, frequencies less than approximately 10 kHz may not provide sufficient bandwidth and could present difficulties in ensuring separation (and thus negligible interference) of the DC and communications signals. Moreover, at frequencies greater than approximately 100 MHz, high frequency effects unacceptable reflections at impedance junctions and antenna effects by components such as the devices (cables).

As described more fully below, the present teachings relate to systems comprising a superconducting magnet adapted to be operated in a driven mode. The system comprises a power supply adapted to supply current to the superconducting magnet.

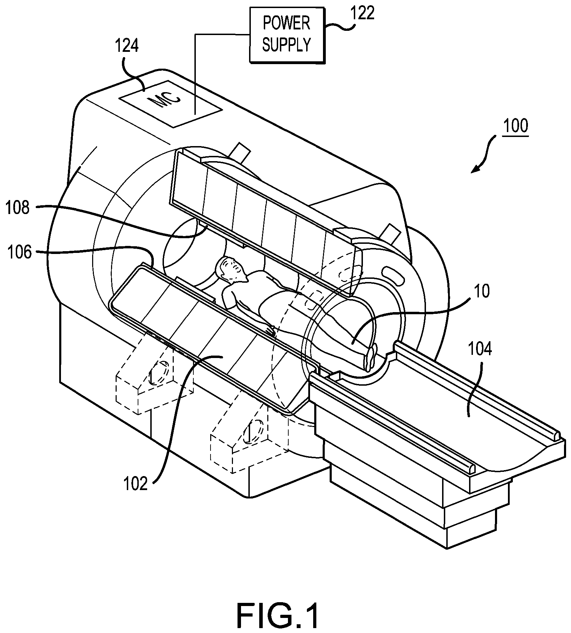

Fig. 1 is a perspective view of a magnetic resonance imaging (MRI) device 100 of a representative embodiment. The MRI device 100 comprises a superconducting magnet apparatus 102; a patient table 104 configured to hold a patient 10; electrically superconducting coils 106 configured to at least partially surround at least a portion of patient 10 for which MRI device 100 generates an image; a radio frequency coil 108 configured to apply a radio frequency signal to at least the portion of patient 10 which is being imaged, and to alter the alignment of the spins with the magnetic field. The superconducting coils 106, when energized by the power supply 122 provide a substantially time-invariant (direct current (DC)) magnetic field used to carry out the imaging. This magnetic field (sometimes referred to as "DC field") is comparatively strong (just by way of example, 0.1T to 3T) to effect the imaging. Notably, certain common components of the MRI device, including a computer and display germane to the imaging function of the MRI device 100 are not shown or disclosed. Moreover, the general operation of an MRI device is known and many aspects of the MRI device 100 are not repeated herein. Rather, the controlled powering of the MRI device 100 is described in detail in various scenarios in accordance with various representative embodiments.

The MRI device 100 further comprises a power supply 122 connected to a magnet controller (MC) 124. In a representative embodiment, the connection between the power supply 122 and the MC 124 comprises cables. As described more fully below, the cables are adapted to provide DC current from the power supply 122 to the superconducting coils 106 in differing amounts based on the state of operation of the superconducting magnet apparatus 102, while at the same time providing a signal transmission between the power supply 122 and the MC 124. As described more fully below, the communication link provided between the power supply 122 and the MC 124 ensures not only proper initial energizing of the superconducting coils 106, but also allows for controlled de-energizing of the superconducting coils and avoidance of quenching of the superconducting coils 106.

In the representative embodiment of Fig. 1, the MC 124 will be an integral component of the MRI device, and may be directly connected to the outer vacuum container (not shown) of the magnet, or disposed in the outer vacuum container. As will be appreciated by one of ordinary skill in the art, the MC 124 is generally in close proximity to the to the current connections to the superconducting coils 106. As will be appreciated by one of ordinary skill in the art, the position where cables or busbars that carry the current to the superconducting coils to enter the vacuum chamber is comparatively close to avoid comparatively long electrical connections, which can have adverse impact on the function of the MRI device 100.

In driven mode there are two current cables connecting the superconducting magnet apparatus 102 with the power supply 122, which is separate, presumably even in a different room (technical room). As alluded to above, and as described more fully below, in addition to providing DC current to the superconducting coils 106 in driven mode, the two current cables also transmit HF signals between the MC 124 and the power supply 122. As will become clearer as the present description continues, among other data, the HF signals are adapted to log information in the MC 124 comprising maintenance information, or operational data of the power supply, or both. The operational data comprises at least one of a power supply type, maintenance intervals, total hours of operation, temperature, and ripple amplitude.

The communication of the HF signals enables various functions to be carried out between the superconducting magnet apparatus 102 and the power supply 122. These functions include, but are not limited to, initiation/verification of the power supply 122 to the superconducting coils 106, ramp-up of the superconducting coils 106 to an energized state, monitoring of the function of the power supply 122 during driven mode, graceful ramp-down (sometimes referred to as a "soft quench") of the superconducting coils 106 in certain situations, and fast ramp-down of the superconducting coils 106 in other (e.g., emergency situations such as described more fully below).

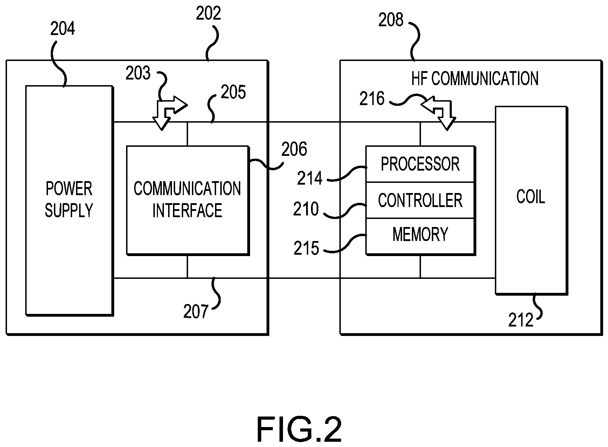

Fig. 2 is a simplified schematic diagram of a power supply device 202 connected to a magnet controller 210 of a magnet apparatus 208 according to a representative embodiment. Various aspects and details of the presently described representative embodiment may be common to those described in the Detailed Description above. These common aspects and details may not be repeated to avoid obscuring the present described representative embodiments.

The power supply device 202 comprises a power supply 204 connected to a communication interface 206 via connections 205, 207 as shown. Generally, and as noted above, the connections may comprise cables or busbars having the capacity to efficiently provide current from the power supply. These may comprise a suitable comparatively thick electrical conductor (e.g., copper or other suitable electrical conductor), illustratively having a cross-sectional area greater than approximately 50 mm². The connections 205, 207 are routed in close vicinity for the current connection (one in, one out) as described more fully below. In certain representative embodiments, a coaxial cable or similar transmission line is contemplated for the connections 205, 207.

The power supply 204 comprises a known circuit adapted to meet the power requirements of a drive superconducting magnet as alluded to above. For the steady state operation, the power supply 204 typically delivers several hundred amperes at voltages of the order of a few volts. During ramping slightly higher voltages of a few tens of volts are required. During ramping an additional inductive voltage appears. Just by way of illustration and not limitation, a magnet having 30 H inductance and using 300 A current will need 300 s ramp-down time, if the power supply keeps/stabilizes the occurring inductive voltage at 30 V.

The superconducting coil adapted to operate in driven mode and is in constant connection with the power supply device 202 via connections 205, 207 as shown. As alluded to above, and as described more fully below, the magnet controller 210 is adapted to communicate with the power supply 204 via the communication interface 206 to ensure proper operation of the superconducting coil 212 in a variety of scenarios. Notably, the magnet controller 210 and the communication interface 206 may be equipped with filters (e.g., a capacitor/inductor filter circuits (not shown)), to block the DC current therethrough and having a pass-band for the HF signals (shown as 203, 216 superposed on connections 205, 207 in Fig. 2) between the power supply device 202 and the magnet apparatus 208 in order to separate the HF communication from the DC current.

In accordance with a representative embodiment, the power supply device 202 may comprise a processor and memory to carry out certain actions. Notably, this processor and memory may be remotely located and connected to the power supply device 202, and may not necessarily be an integral component of the power supply device 202. These actions include, for example, by execution of instructions stored in memory by the processor, transmission by the power supply device 202 of information regarding the particular power supply 204 being used. The power supply device may also transmit status signals regarding the current operational health of the power supply 204 to the magnet controller 210. These status signals, in turn, may cause action to be taken by the magnet controller 210 to avoid damage to the superconducting coil 212.

The magnet apparatus 208 also comprises the magnet controller 210, which comprises a processor 214 and a memory 215. In the representative embodiment, the processor 214 and memory are integrated into the magnet apparatus. In other representative embodiments, the processor 214 and memory 215 may be remotely located and connected to the magnet controller 210. The magnet apparatus 208 further comprises a superconducting coil 212.

The power supply 204 is connected via the same connections 205, 207 to communication interface 206. The communication interface 206 is adapted to transmit and receive HF communications signals between the power supply 204 and the magnet apparatus 208, and especially between the power supply 204 and the magnet controller 210. As alluded to above, and as described more fully below, the communication interface 206 enables action to be taken by the magnet controller 210 to ensure proper operation of the magnet apparatus 208 while avoiding damaging events such as quenching of the superconducting coils. While a number of communication interfaces are contemplated, the communication interface 206 is contemplated to be a serial interface within the purview of the ordinarily skill artisan, and is adapted to decode the presence and absence of HF signals transmitted along the connections 205, 207. As noted above, and as described more fully below, the communication interface 206 enables the magnet controller 210 to ensure proper start-up, ramp-up and ramp-down of the magnet, while avoiding quenching of the superconducting coil 212. In accordance with an illustrative embodiment, the communications interface may comprise a 1-Wire serial bus. As is known, the 1-Wire is a wired half-duplex serial bus provides comparatively low-speed (16.3 kbit/s) data communication and supply voltage over a conductor (e.g., connections 205, 207). 1-Wire is similar in concept to the known I²C protocol, but with lower data rates and longer range. One distinctive feature of the 1-wire bus is the ability to use only two conductors - data/power and ground, which lends itself nicely to the architecture including the connections 205, 207, which provide the DC power to the magnet apparatus 208. Finally, it is noted according to the 1-Wire standard, a master is in control of actions via the 1-Wire link. In the presently described representative embodiment, the magnet controller 210 functions as the master. As will be appreciated, the magnet controller (the master) initiates activity on the bus, simplifying the avoidance of collisions on the bus. Protocols are built into the software of the magnet controller to detect collisions. After a collision, the master retries the required communication.

In another illustrative embodiment, the communication interface 206 comprises a capacitor having suitable capacitance to enable discharge of the superconducting coil. In this case, the magnet controller 210 can transmit alternating current (AC) through capacitor. In this case, the capacitor functions as a short enabling transmission of signals between the power supply 204 and the magnet controller 210. If one or both of the connections 205, 207 are disconnected, the capacitor would function as an open circuit, and immediately, the magnet controller 210 would sense this state, and terminate action by the power supply 204.

The processor 214 of the magnet controller 210 and other noted processors noted above are representative of one or more processing devices, and is configured to execute software instructions to perform functions of the magnet controller as described in the various embodiments herein. The processors of various representative embodiments may be implemented by field programmable gate arrays (FPGAs), application specific integrated circuits (ASICs), a general purpose computer (which is transformed to being a specialty purpose computer through the inclusion of the machine-learning algorithms and trained machine learning models of the present teachings), a central processing unit, a computer processor, a microprocessor, a microcontroller, a state machine, programmable logic device, or combinations thereof, using any combination of hardware, software, firmware, hard-wired logic circuits, or combinations thereof. Additionally, any processing unit or processor herein may include multiple processors, parallel processors, or both. Multiple processors may be included in, or coupled to, a single device or multiple devices.

The term "processor" as used herein encompasses an electronic component able to execute a program or machine executable instruction. References to a computing device comprising "a processor" should be interpreted to include more than one processor or processing core, as in a multi-core processor. A processor may also refer to a collection of processors within a single computer system or distributed among multiple computer systems, such as in a cloud-based or other multi-site application. The term computing device should also be interpreted to include a collection or network of computing devices each including a processor or processors. Programs have software instructions performed by one or multiple processors that may be within the same computing device or which may be distributed across multiple computing devices.

The memory 215 and other memories noted above, are adapted to store data (e.g., log data of the magnet apparatus) and software (computer executable code, or instructions) and may comprise a main memory and/or a static memory, where such memories may communicate with each other via one or more buses. The memory 215 stores instructions used to implement some or all aspects of methods and processes described herein. The memory may be implemented by any number, type and combination of random access memory (RAM) and read-only memory (ROM), for example, and may store various types of information, such as software algorithms, which serves as instructions, which when executed by a processor cause the processor to perform various steps and methods according to the present teachings. For example, in accordance with various representative embodiments, the memory 215 that stores instructions, which when executed by the processor 214, cause the processor 214 to send and receive signals relating to the health and operational status of the power supply 204 and to cause the processor 214 to provide commands to the power supply 204 to engage in certain activities, such as described more fully below.

The various types of ROM and RAM may include any number, type and combination of computer readable storage media, such as a disk drive, flash memory, an electrically programmable read-only memory (EPROM), an electrically erasable and programmable read only memory (EEPROM), registers, a hard disk, a removable disk, tape, compact disk read only memory (CD-ROM), digital versatile disk (DVD), floppy disk, Blu-ray disk, a universal serial bus (USB) drive, or any other form of storage medium known in the art. The memory of the present teachings (e.g., memory 215) is a tangible storage medium for storing data and executable software instructions, and is non-transitory during the time software instructions are stored therein. As used herein, the term "non-transitory" is to be interpreted not as an eternal characteristic of a state, but as a characteristic of a state that will last for a period. The term "non-transitory" specifically disavows fleeting characteristics such as characteristics of a carrier wave or signal or other forms that exist only transitorily in any place at any time. The memory may store software instructions and/or computer readable code that enable performance of various functions. The memory may be secure and/or encrypted, or unsecure and/or unencrypted.

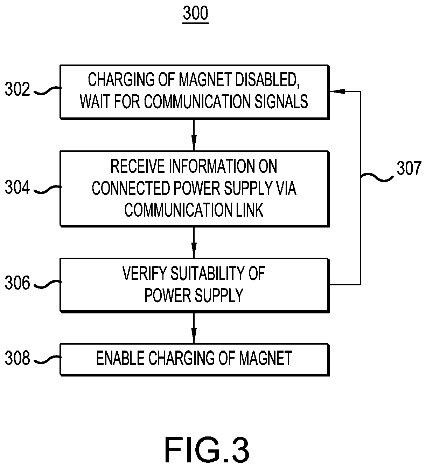

Figs. 3-5 are flow-charts of illustrative methods of various representative embodiments. As alluded to above, these methods are carried out by the execution by the processor 214 of instructions stored in memory 215 of the magnet controller 210, and enable the safe start-up, ramp-up, safe ramp-down and monitoring of the power supply 204 and the connections 205, 207. These methods further comprise steps to carry out a comparatively fast ramp-down of the superconducting coil 212 in certain scenarios to avoid quenching of the superconducting coil 212 or damage thereto.

Turning to Fig. 3 a method 300 of initiating operation of the superconducting coil 212 in the magnet apparatus 208 is disclosed.

The method 300 begins at 302 at which the charging of the magnet is disabled, and the magnet controller 210 is in a stand-by mode waiting for a control signal from an operator to send a signal to initiate ramp-up.

At 304, information is received from the power supply relating to its identity. To this end, in a representative embodiment, after receiving the command to begin energizing the superconducting coil 212, at 306 the magnet controller 210 queries the power supply 204 regarding identifying criteria to ensure the correct power supply being connected is suitable for the superconducting coil 212. As such, the magnet controller 210 verifies the identity of the power supply 204 as being suitable for use in a ramp-up of the superconducting coil 212.

At 308, charging of the superconducting coil 212 begins and continues until the superconducting coil is fully energized. Notably, once the superconducting coil 212 is energized, because it is nearly superconducting, electrical power loss is comparatively low, the power supply 204 does not need to provide significant electrical power (e.g., a few Watts of power) to the fully charged superconducting coil 212.

At this point, monitoring of the operation of the power supply 204 and the superconducting coil 212 of the magnet apparatus begins.

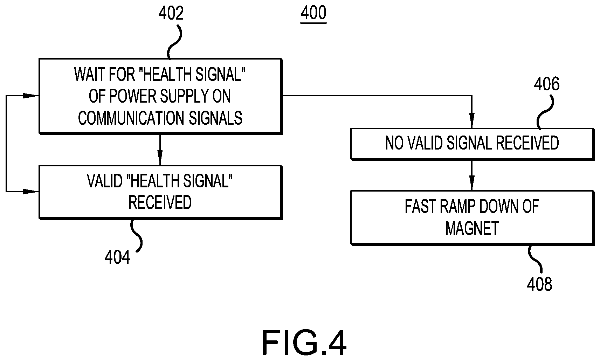

Turning to Fig. 4, a method 400 of monitoring the functioning of the power supply 204 by the magnet controller 210 according to a representative embodiment is shown.

At 402, the magnet controller 210 waits for a status or "health signal" to be received from the power supply 204. Notably, the power supply 204 may be adapted to transmit a status signal to the magnet controller 210 at predetermined time intervals via the communication interface 206, or the magnet controller 210 may be adapted to query the power supply 204 (again via the communications link) of its current status at predetermined time intervals, or both may occur.

At 404, a valid status signal regarding the operational health of the power supply 204 is received at the magnet controller 210 resulting from the transmission of a valid "health signal" by the power supply, or in response to a query sent to the power supply 204 by the magnet controller. When this valid health signal is received, the function of the power supply 204 remains unchanged and the superconducting coil 212 continues to function in an energized state.

At 406, the method 400 includes a step when no valid status (health) signal is received by the magnet controller 210. Specifically, either after a certain period time a valid status signal is not received from the power supply 204, or in a certain period of time after a query is sent by the magnet controller 210 to the power supply 204, action must be taken to avoid damage to the superconducting coil 212. At 408 the method comprises a fast ramp-down of the superconducting coil 212. This may be done, for example, by disconnecting the connections 205, 207 and connecting the superconducting coil 212 to a discharge circuit, such as a diode circuit noted above. In this way, the current in the superconducting coil 212 is ramped down in a controlled way by dissipating the stored energy of the magnetic field in the diodes or resistors. These can withstand the heat produced and can be sufficiently cooled (e.g., using big metal parts as heat sinks). No additional heat will be produced inside the superconducting coil, thus avoiding a quench.

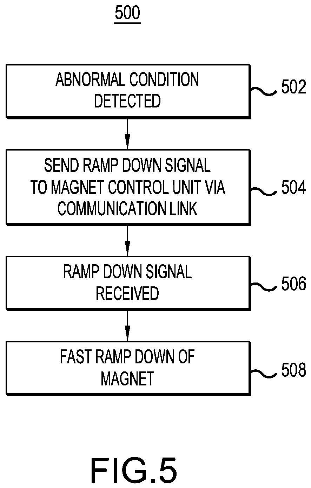

Turning to Fig. 5 a method of rapidly ramping down the superconducting coil 212 is described in connection with a representative embodiment.

At 502 an abnormal condition is detected. This abnormal condition may be, for example an inconsistent status of the power supply regarding its current and voltage; temperature readings that are too high; and/or other abnormal operational parameter of the power supply 204. Moreover, there can be other operational parameters that can be measured by sensors and that are transmitted by the communication interface 206 of the power supply. These can be, for example, sensors for measuring temperature, humidity, pressure, and flow and temperature of coolants. Data from these sensor can also be used to identify abnormal conditions at 502.

The abnormal condition may be received in response to a query made by the magnet controller 210, or may be transmitted from the power supply device 202 as alluded to above.

At 504, the power supply device 202 transmits a ramp-down signal to the magnet controller 210 via the communication interface 206.

At 506, the ramp down signal is received at the magnet controller 210 and at 510, a fast ramp down of the superconducting coil is carried out. Again, as alluded to above, this fast ramp down may be via a dedicated circuit (e.g., a diode circuit) within the purview of one of ordinary skill in the art.

In the embodiments described in connection with methods 300-500, action to ramp down the superconducting coil 212 is carried out in response to an issue in the power supply device 202. These are merely illustrative. In another representative embodiment, when an issue arises in the magnet apparatus 208, the magnet controller 210 is also adapted to act in response thereto. Just by way of example, if an unacceptable increase in temperature in the superconducting coil 212, or a pressure loss in the cryogenic chamber housing the superconducting coil occurs, the magnet controller 210 is adapted to instruct via the communication interface 206 the power supply device 202 to terminate power to the magnet apparatus 208. In this case a soft ramp down is initiated. In a soft ramp-down, the power supply 204 slowly reduces current provided to the magnet. The corresponding inductive voltages are typically kept lower than 50 volts, and deenergizing the magnet apparatus 208/superconducting coil 212 may take several minutes to complete. The corresponding energy is dissipated in the power supply. In case a faster decay is needed, the fast ramp-down described above has to be applied.

One or more embodiments of the disclosure may be referred to herein, individually and/or collectively, by the term "invention" merely for convenience and without intending to voluntarily limit the scope of this application to any particular invention or inventive concept. Moreover, although specific embodiments have been illustrated and described herein, it should be appreciated that any subsequent arrangement designed to achieve the same or similar purpose may be substituted for the specific embodiments shown. This disclosure is intended to cover any and all subsequent adaptations or variations of various embodiments. Combinations of the above embodiments, and other embodiments not specifically described herein, will be apparent to those of skill in the art upon reviewing the description.

The Abstract of the Disclosure is provided to comply with 37 C.F.R. §1.72(b) and is submitted with the understanding that it will not be used to interpret or limit the scope or meaning of the claims. In addition, in the foregoing Detailed Description, various features may be grouped together or described in a single embodiment for the purpose of streamlining the disclosure. This disclosure is not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

The preceding description of the disclosed embodiments is provided to enable any person skilled in the art to practice the concepts described in the present disclosure. As such, the above disclosed subject matter is to be considered illustrative, and not restrictive, and the appended claims are intended to cover all such modifications, enhancements, and other embodiments which fall within the true spirit and scope of the present disclosure. Thus, to the maximum extent allowed by law, the scope of the present disclosure is to be determined by the broadest permissible interpretation of the following claims and their equivalents and shall not be restricted or limited by the foregoing detailed description.

## Claims

1. A superconducting apparatus, comprising:
a magnet comprising an electrically superconductive coil adapted to function in a driven mode;
a magnet controller (210) connected to the magnet;
a power supply (122) adapted to provide direct current, DC, power to the magnet;
an electrical connection disposed between the magnet to provide the DC power to the magnet; and
a communication interface (206) adapted to communicate signals across a cable between the power supply (122) and the magnet controller (210), wherein the signals from between the communication interface (206) and the magnet controller (210) are high-frequency, HF, signals that do not substantially interfere with the DC power transmitted across the cable.

2. The superconducting apparatus of claim 1, wherein the HF signals have a frequency of at least 10 kHz.

3. The superconducting apparatus of claim 1, wherein the HF signals have a frequency in the range of approximately 10 kHz to approximately 100 MHz.

4. The superconducting magnet of claim 1, further comprising a processor (214) and a tangible non-transitory computer readable medium that stores instructions, which when executed by the processor (214), cause the processor (214) to initiate a connection between the power supply (122) and the magnet to supply the DC power supply (122) to the magnet based on the HF signals indicative of a compatible DC power supply (122).

5. The superconducting magnet of claim 1, further comprising a processor (214) and a tangible non-transitory computer readable medium that stores instructions, which when executed by the processor (214), cause the processor (214) to prevent a connection between the power supply (122) and the magnet to supply the DC power supply (122) to the magnet based on the HF signals indicative of an incompatible DC power supply (122).

6. The superconducting magnet of claim 4, wherein after the magnet is functioning in the driven mode, the instructions further cause the processor (214) to initiate a controlled emergency ramp-down of the magnet based on the HF signals indicative of an abnormal condition in the power supply (122).

7. The superconducting magnet of claim 1, wherein the HF signals are adapted to log information in the magnet controller (210) comprising maintenance information, operational data of the power supply (122), or both.

8. The superconducting magnet of claim 7, wherein the operational data comprises at least one of: power supply (122) type, maintenance intervals, total hours of operation, temperature, and ripple amplitude.

9. A magnetic resonance imaging, MRI, device (100), comprising a superconducting apparatus according to any of the claims 1 to 8.

10. A method (300) of controlling a magnet comprising an electrically superconductive coil adapted to be operated in a driven mode, the method (300) comprising:
providing direct current, DC, power to the magnet over a cable between a power supply (122) and the magnet; and
communicating signals across the cable between the power supply (122) and the magnet controller (210), wherein the signals from between the communication interface (206) and the magnet controller (210) are high-frequency, HF, signals that do not substantially interfere with the DC power transmitted across the cable.

11. The method (300) of claim 10, wherein the HF signals have a frequency of at least 10 kHz.

12. The method (300) of claim 10, wherein the HF signals have a frequency in the range of approximately 10 kHz to approximately 100 MHz.

13. The method (300) of any of the claims 10 to 12, further comprising initiating a connection between the power supply (122) and the magnet to supply the DC power supply (122) to the magnet based on the HF signals indicative of a compatible DC power supply (122).

14. The method (300) of any of the claims 10 to 13, further comprising preventing a connection between the power supply (122) and the magnet to supply the DC power supply (122) to the magnet based on the HF signals indicative of an incompatible DC power supply (122).

15. The method (300) of any of the claims 10 to 14, wherein after the magnet is functioning in the driven mode, the method (300) further comprising initiating a controlled emergency ramp-down of the magnet based on the HF signals indicative of an abnormal condition in the power supply (122).
